(19) Europäisches Patentamt

European Patent Office

Office européen des brevets

(11) **EP 1 074 848 A1**

(12) **EUROPEAN PATENT APPLICATION**

(43) Date of publication:
07.02.2001 Bulletin 2001/06

(51) Int. Cl.⁷: **G01R 15/20**

(21) Application number: **00116811.1**

(22) Date of filing: **03.08.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **03.08.1999 US 368023**

(71) Applicant: **EATON CORPORATION**
**Cleveland, Ohio 44114-2584 (US)**

(72) Inventors:
• **Juds, Mark Allen**
**New Berlin, Wisconsin 53146 (US)**
• **Eckroth, Kurt Von**
**Oconomowoc, Wisconsin 53066 (US)**
• **Tennies, Charles Joseph**
**Waukesha, Wisconsin 53188 (US)**

• **Hansen, James Edward**
**Oak Creek, Wisconsin 53154 (US)**
• **Solveson, Mark George,**
**c/o Eaton Corporation**
**Cleveland, Ohio 44114-2584 (US)**
• **Hasting, James Kenneth**
**Sussex, Wisconsin 53089 (US)**
• **Reid, Scott**
**Brookfield, Wisconsin 53005 (US)**

(74) Representative:
**Wagner, Karl H., Dipl.-Ing. et al**
**Wagner & Geyer,**
**Patentanwälte,**
**Gewürzmühlstrasse 5**
**80538 München (DE)**

(54) **Electrical current sensor**

(57)     A first magnetic flux sensor (22) is disposed in a magnetic field (14, 16) emanating from an electrical conductor. A second magnetic flux sensor (24) is also disposed in the magnetic field (14, 16) emanating from the electrical conductor. The second magnetic flux sensor (24) is spaced further from the conductor than the first magnetic flux sensor (22). The ratio output of the two magnetic flux sensors (22, 24) will remain constant as long as the two magnetic flux sensors are not exposed to extraneous magnetic fields. When the two magnetic flux sensors (22, 24) are exposed to extraneous magnetic fields, the ratio between the outputs from the two magnetic flux sensors will change. This enables controls (38) connected with the two magnetic flux sensors (22, 24) to determine whether a change in the strength of the magnetic field sensed by the two magnetic flux sensors is due to a change in electrical current being conducted through the conductor or due to exposure of the sensors to extraneous magnetic fields. The difference of the output of the two magnetic flux sensors (22, 24) will be proportional to the current in the electrical conductor and independent of the extraneous magnetic flux produced by an external source.

Fig.1

EP 1 074 848 A1

**Description**

**Background of the Invention**

The present invention relates to a new and improved apparatus for sensing electrical current conducted through an electrical conductor.

During the conducting of electrical current through an electrical conductor, a magnetic field is produced around the electrical conductor. The strength of this magnetic field is indicative of the magnitude of the current being conducted through the electrical conductor. It has previously been suggested that a magnetic flux sensor could be utilized to detect the magnetic field around an electrical conductor to thereby detect the magnitude of the current being conducted through the electrical conductor. However, the magnetic flux sensor may be exposed to extraneous magnetic fields and provide an erroneous output due to the effect of the extraneous magnetic fields.

**Summary of the Invention**

The present invention provides a plurality of magnetic flux sensors which are spaced different distances from an electrical conductor. Controls compare the output from the magnetic flux sensors to detect the magnitude of the current being conducted through the electrical conductor. Since the magnetic flux sensors are located different distances from the electrical conductor, a predetermined relationship will be maintained between the output from the two magnetic flux sensors regardless of the current being conducted through the electrical conductor. Exposure of the magnetic flux sensors to an extraneous magnetic field will alter the ratio between the output from the two magnetic flux sensors. This enables controls to detect when a change in the output of the magnetic flux sensors is due to extraneous magnetic fields. However, the difference between the output from the two magnetic flux sensors is directly proportional to the electrical current and to the difference between the inverse of the sensor distances from the electrical conductor, and the effects from the external magnetic fields are completely eliminated. Alternatively, the magnetic flux sensors may be positioned at opposite sides of the electrical conductor at the same or different distances, and the output signals algebraically summed by the controls, to eliminate the effects of extraneous magnetic fields.

**Brief Description of the Drawings**

The foregoing and other objects and features of the present invention will become more apparent upon a consideration of the following description taken in connection with the accompanying drawing wherein:

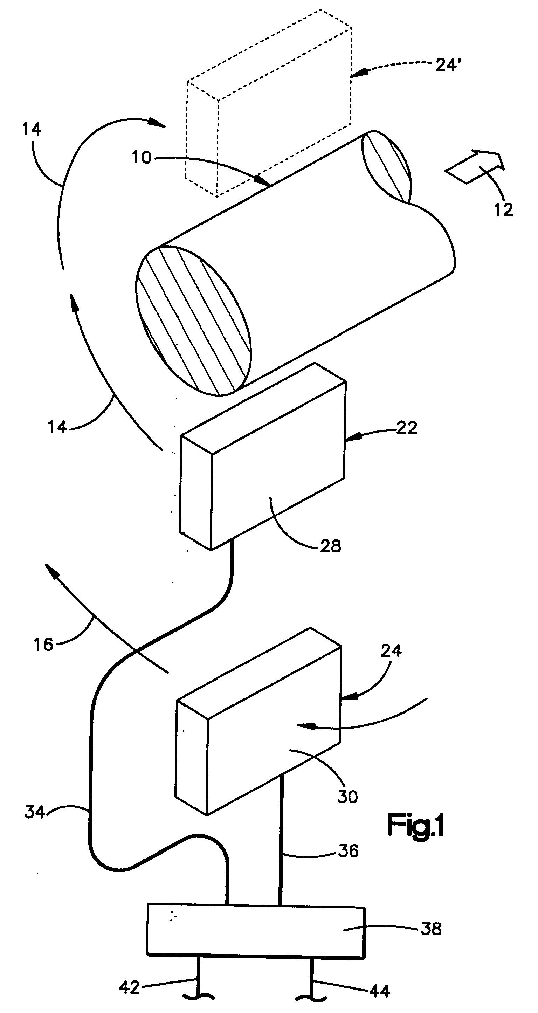

Fig. 1 is a simplified schematic pictorial illustration of an electrical current sensing apparatus constructed in accordance with the present invention.

**Description of One Specific Preferred Embodiment of the Invention**

A cylindrical electrical conductor 10 conducts electrical current, indicated schematically by an arrow 12 in Fig. 1. A magnetic field is produced by the electrical current 12 in the conductor 10. Lines of flux forming the magnetic field have been indicated schematically by arrows 14 and 16 in Fig. 1.

The strength of the magnetic field produced by the current 12 is a direct function of the magnitude of the current. However, for any given magnitude of current 12, the strength of the magnetic field produced by the current varies as an inverse function of the distance from the conductor 12.

The line of flux indicated schematically by the arrow 14 is disposed closer to the conductor 10 than the line of flux indicated by the arrow 16. Therefore, the strength of the portion of the magnetic field indicated by the line of flux 14 is greater than the strength of the portion of the magnetic field indicated by the line of flux 16. The ratio of the strength of the portion of the magnetic field indicated by the arrow 14 to the strength of the portion of the magnetic field indicated by the arrow 16 will remain constant regardless of the magnitude of the current 12 conducted through the conductor 10. The ratio of the strengths of the portions of the magnetic fields indicated by the arrows 14 and 16 will only vary when a magnetic field from a source other than the current 12 is added to the magnetic field emanating from the current 12.

A pair of magnetic flux sensors 22 and 24 are disposed in the magnetic field produced by the current 12 in the electrical conductor 10 and are spaced different distances from the electrical conductor. Thus, the magnetic flux sensor 22 is closer to the conductor 10 than the magnetic flux sensor 24. A relatively strong magnetic flux, indicated by the arrow 14, passes through a sensitive surface 28 of the magnetic flux sensor 22. A relatively weak magnetic flux, indicated by the arrow 16, passes through a sensitive surface 30 of the magnetic flux sensor 24. Although the magnetic flux sensors 22 and 24 could have many different constructions, in the illustrated embodiment of the invention, the magnetic flux sensors 22 and 24 are Hall effect sensors.

In the specific embodiment of the invention illustrated in Fig. 1, the sensitive side surfaces 28 and 30 of the magnetic flux sensors 22 and 24 are disposed in a common plane which forms a radius of the conductor 10. However, it should be understood that the magnetic flux sensors 22 and 24 could be located differently relative to each other and the conductor 10. For example, the magnetic flux sensors 22 and 24 could be positioned on opposite sides of the conductor 10 at the same or different radial distance from the electrical conductor as will be described later.

The output from the magnetic flux sensors 22 and 24 is conducted by leads 34 and 36 to a controller 38. The controller uses the output from the magnetic flux sensor 22 to determine the magnitude of the current in a known manner. The controller 38 also compares the output from the magnetic flux sensor 22 to the output from the magnetic flux sensor 24. In the absence of extraneous magnetic fields, the ratio of the outputs from the sensors 22 and 24 will remain constant with variations in the magnitude of the current 12.

The output from the magnetic flux sensor 22, which is closer to the electrical conductor 10, will be greater than the output from the magnetic flux sensor 24. The outputs from the magnetic flux sensors 22 and 24 will be in a ratio relative to each other determined by distances the flux sensors are spaced from the electrical conductor 10. Thus, the output from the magnetic flux sensor 22 will exceed the output from the magnetic flux sensor 24 by a ratio which is determined by their relative spacing.

The strength of the magnetic field around the conductor 10 is directly proportional to the electrical current 12 conducted through the conductor 10. However, regardless of the absolute magnitude of the outputs from the magnetic flux sensors 22 and 24, they will be in the same ratio relative to each other as long as the magnetic flux sensors 22 and 24 are exposed to only magnetic flux produced by the electrical current 12.

If the magnetic flux sensors 22 and 24 are exposed to extraneous flux fields, for example a flux field from an adjacent conductor (not shown), the ratio of the outputs from the magnetic flux sensors 22 and 24 will have a ratio relative to each other which is different than the ratio of the output signals from the magnetic flux sensors 22 and 24 when the magnetic flux sensors are exposed to only magnetic flux emanating from the electrical current 12. As long as the outputs from the magnetic flux sensors 22 and 24 are in the predetermined ratio relative to each other, the magnetic flux sensors 22 and 24 are being exposed to only magnetic flux emanating from the electrical current 24. However, when the ratio of the output from the magnetic flux sensor 22 to the output from magnetic flux sensor 24 is different than the predetermined ratio, it is clear that the magnetic flux sensors 22 and 24 are being exposed to extraneous flux fields.

The controller 38 compares the output from the magnetic flux sensor 22 to the output from the magnetic flux sensor 24. In the event that the ratio of the output from the magnetic flux sensor 22 to the output of the magnetic flux sensor 24 differs from the predetermined ratio, the controller 38 provides a signal over a lead 42 indicating that the magnetic flux sensors have been exposed to an extraneous magnetic field.

In addition, the controller 38 provides a signal over a lead 44 which is equal to the difference between the output from the magnetic flux sensor 22 and the output from the magnetic flux sensor 24. The difference between the outputs from the magnetic flux sensors 22 and 24 will vary as a direct function of variations in the magnitude of the current 12 through the conductor 10. The difference between the outputs from the magnetic flux sensors 22 and 24 will differ by an amount which is an inverse function of the distance of the magnetic flux sensors from the conductor 10. The effects of external fields are completely eliminated. Therefore, the difference in the magnitude of the signals from the flux sensors 22 and 24 and the signal provided over the lead 44 is proportional to the current in the electrical conductor 10.

In order to eliminate the effects of external magnetic fields, the magnetic flux sensors 22 and 24 are located relatively close together and in a common plane. However, the magnetic flux sensors 22 and 24 are located different distances from the conductor. Since the magnetic flux sensors 22 and 24 are located relatively close together, an external magnetic field will have the same effect on both magnetic flux sensors.

The signal provided by the magnetic flux sensor 22 ($SIG_{22}$) is a direct function ($\propto$) of the current 12 ($I_{12}$) in the conductor 10 and the strength of any external magnetic field ($\beta_{EXT}$) and is an inverse function of the distance ($R_{22}$) the magnetic flux sensor 22 is located from the conductor 10. This may be expressed as:

$$SIG_{22} \propto \mu_o \frac{I_{12}}{2\pi R_{22}} + \beta_{EXT}$$

The signal provided by the magnetic flux sensor 24 ($SIG_{24}$) is a direct function ($\propto$) of the current ($I_{12}$) in the conductor 10 and the strength of any external magnetic field ($\beta_{EXT}$) and is an inverse function of the distance ($R_{24}$) the magnetic flux sensor 24 is located from the conductor 10. This may be expressed as:

$$SIG_{24} \propto \mu_o \frac{I_{12}}{2\pi R_{24}} + \beta_{EXT}$$

When there is no external magnetic field, $\beta_{EXT} = 0$. This results in the ratio of the signal from the magnetic flux sensor 22 ($SIG_{22}$) to the signal from the magnetic flux sensor 24 ($SIG_{24}$) being a function of only the distance ($R_{22}$ and $R_{24}$) which the magnetic flux sensors 22 and 24 are spaced from the conductor 10. Therefore, when $B_{EXT} = 0$:

$$\frac{SIG_{22}}{SIG_{24}} = \frac{R_{24}}{R_{22}}$$

Since the distance which the magnetic flux sensors 22 and 24 are spaced from the conductor 10 is known and remains constant, the ratio of the signals provided by the flux sensors is known and remains constant as long as there are no external magnetic fields.

As was previously mentioned, the difference between the outputs from the magnetic flux sensors 22 and 24 ($SIG_{22}$ - $SIG_{24}$) is directly proportional to the current 12 ($I_{12}$) in the conductor 10 and is independent of the effects of external magnetic fields ($\beta_{ExT}$). This is because the effects of external magnetic fields is cancelled out. Therefore, when the outputs from the magnetic flux sensors 22 and 24 are subtracted:

$$SIG_{22} - SIG_{24} = \mu_o \frac{I_{12}}{2\pi}\left(\frac{1}{R_{22}} - \frac{1}{R_{24}}\right)$$

For any given system the distances ($R_{22}$ and $R_{24}$) which the flux sensor 22 and 22 are located from the conductor are constant. Therefore:

$$SIG_{22} - SIG_{24} \propto I_{12}.$$

The effects of an external magnetic field may also be eliminated for other sensor pair arrangements, leaving the sensor outputs to be indicative solely of variations in current magnitude in the conductor. For example, if two magnetic flux sensors are located at opposite sides of the conductor, still in a common plane, as represented by the dotted line showing of sensor 24' in Fig. 1, then the flux of an external magnetic field would be opposed to the flux 14 from current 12 in the conductor 10 for one of the sensors 24 or 24'. Thus, to eliminate the effects of an external magnetic field in this arrangement, the comparison by the controller 38 must algebraically sum the signals from sensors 22 and 24'. In this arrangement, the sensors may be at the same radial distance from the electrical conductor.

It will be recognized by those skilled in the art that magnetic flux sensors may have a polarity, i.e. positively sensitive to flux in a particular direction. The foregoing description and equations are valid for polarity insensitive magnetic flux sensors and for polarity sensitive magnetic flux sensors which have their polarity aligned with the magnetic field produced around the electrical conductor by current in the conductor. However, if one sensor is reversed in polarity, then the controller 38 is made to perform the opposite algebraic operation than that described in the foregoing in order to eliminate the effects of the external magnetic field.

The present invention provides a plurality of magnetic flux sensors 22 and 24 or 24' which are particularly positioned around an electrical conductor 10. A controller 38 compares the output from the magnetic flux sensors 22 and 24 or 24' to detect the magnitude of the current 12 being conducted through the electrical conductor. The positioning of the magnetic flux sensors 22 and 24 or 24' and the algebraic operation of the controller 38 are selected to eliminate the effects of an extraneous magnetic field on magnetic flux sensors 22 and 24 or 24', maintaining a predetermined relationship between the output from the two magnetic flux sensors with the current being conducted through the electrical conductor. Exposure of the magnetic flux sensors 22 and 24 or 24' to an extraneous magnetic field will alter the relationship between the output from the two magnetic flux sensors. This enables controller 38 to detect when a change in the output of the magnetic flux sensors 22 and 24 or 24' is due to extraneous magnetic fields.

## Claims

**Having described the invention, the following is claimed:**

1. An electrical current sensing apparatus comprising an electrical conductor (10), a first magnetic flux sensor (22) disposed in a magnetic field (14, 16) around said electrical conductor and providing a first output, a second magnetic flux sensor (24, or 24') disposed in the magnetic field (14, 16) around said electrical conductor and providing a second output, said first and second magnetic flux sensors being disposed in a common plane through said electrical conductor, and control means (38) connected with said first and second magnetic flux sensors for comparing said first and second outputs, said control means algebraically operating on said first and second outputs for eliminating effects of an extraneous magnetic field upon said first and second magnetic flux sensors (22 and 24 or 24').

2. An apparatus as set forth in claim 1 wherein said control means (38) is effective to determine when the relationship between the first and second outputs changes due to the effect of an extraneous magnetic field on said first and second magnetic flux sensors (22 and 24 or 24').

3. An apparatus as set forth in claim 1 wherein said control means (38) is operable to determine when there is a predetermined relationship between the first and second outputs from said magnetic flux sensors (22 and 24 or 24').

4. An apparatus as set forth in claim 3 wherein said control means (38) is effective to provide an output signal in response to the relationship between said first and second outputs changing from the predetermined relationship.

5. An apparatus as set forth in claim 1 wherein said control means (38) provides an output signal which is proportional to the current in an electrical conductor and is free of the effects from extraneous magnetic fields.

6. An apparatus as set forth in claim 5 wherein said output signal is proportional to the difference between the first and second outputs.

7. An apparatus as set forth in claim 5 wherein said output signal is proportional to the sum of the first and second outputs.

8. An apparatus as set forth in claim 1 wherein said first magnetic sensor (22) is disposed at a first distance from said electrical conductor and said second magnetic flux sensor (24) is disposed on a same side of said electrical conductor as said first magnetic flux sensor, said second magnetic flux sensor (24) being disposed at a second distance from said electrical conductor, said second distance being greater than said first distance.

9. An apparatus as set forth in claim 1 wherein said first and second magnetic flux sensors (22 and 24') are disposed on respective opposite sides of said electrical conductor.

10. An apparatus as set forth in claim 9 wherein said first and second magnetic flux sensors (22 and 24') are disposed at equal distances from said electrical conductor.

**Fig.1**

**European Patent Office**

## EUROPEAN SEARCH REPORT

Application Number

EP 00 11 6811

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 930 507 A (CHAUVIN ARNOUX) 21 July 1999 (1999-07-21) * column 2, line 54 - column 3, line 22 * | 1,8 | G01R15/20 |
| X | WO 90 11529 A (ABB STROEMBERG KOJEET OY) 4 October 1990 (1990-10-04) * claim 5; figure 7 * | 1,8 | |

TECHNICAL FIELDS SEARCHED (Int.Cl.7)

G01R

The present search report has been drawn up for all claims

| Place of search | Date of completion of the search | Examiner |
|---|---|---|
| THE HAGUE | 2 November 2000 | Six, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 00 11 6811

This annex lists the patent family members relating to the patent documents cited in the above-mentioned European search report.
The members are as contained in the European Patent Office EDP file on
The European Patent Office is in no way liable for these particulars which are merely given for the purpose of information.

02-11-2000

| Patent document cited in search report | | Publication date | Patent family member(s) | | Publication date |
|---|---|---|---|---|---|
| EP 0930507 | A | 21-07-1999 | FR | 2773617 A | 16-07-1999 |
| | | | DE | 930507 T | 31-08-2000 |
| | | | ES | 2146571 T | 16-08-2000 |
| WO 9011529 | A | 04-10-1990 | FI | 891437 A | 24-09-1990 |
| | | | FI | 894792 A,B, | 24-09-1990 |
| | | | AU | 5282090 A | 22-10-1990 |
| | | | DE | 69009053 D | 23-06-1994 |
| | | | DE | 69009053 T | 22-12-1994 |
| | | | EP | 0464076 A | 08-01-1992 |